# EUROPÄISCHE PATENTSCHRIFT

(11) **EP 0 770 699 B1**
(45) Veröffentlichungstag und Bekanntmachung des Hinweises auf die Patenterteilung: **03.04.2002**
(21) Anmeldenummer: 96116564.4
(22) Anmeldetag: 16.10.1996
(51) Int. Cl.: C23C 14/12, G02B 1/10, C03C 17/30

(54) **Herstellung von wasserabweisenden Beschichtungen auf optischen Substraten**
Manufacturing of water-repellent coating on optical substrate
Préparation d'une couche imperméable sur un substrat optique

(30) Priorität: 26.10.1995 DE 19539789
(43) Veröffentlichungstag der Anmeldung: 02.05.1997
(73) Patentinhaber: MERCK PATENT GmbH, 64293 Darmstadt (DE)
(72) Erfinder: Dombrowski, Reiner, 64739 Höchst (DE); Friz, Martin, Dr., 64367 Mühltal (DE)

(56) Entgegenhaltungen:
- EP-A- 0 367 438
- EP-A- 0 561 016
- DE-A- 3 701 654
- US-A- 4 944 962
- DATABASE WPI Section Ch, Week 9332 Derwent Publications Ltd., London, GB; Class E11, AN 93-252524 XP002077601 & JP 05 170487 A (CENTRAL GLASS CO LTD) , 9. Juli 1993
- PATENT ABSTRACTS OF JAPAN vol. 018, no. 142 (P-1706), 9. März 1994 & JP 05 323107 A (MATSUSHITA ELECTRIC WORKS LTD), 7. Dezember 1993
- DATABASE WPI Section Ch, Week 9423 Derwent Publications Ltd., London, GB; Class A35, AN 94-186606 XP002077602 & JP 06 122962 A (NASU NIKON KK) , 6. Mai 1994
- PATENT ABSTRACTS OF JAPAN vol. 017, no. 704 (C-1146), 22. Dezember 1993 & JP 05 239243 A (SHINKURON:KK), 17. September 1993
- DATABASE WPI Section Ch, Week 9339 Derwent Publications Ltd., London, GB; Class A26, AN 93-305924 XP002077603 & JP 05 215905 A (HOYA CORP) , 27. August 1993

## Beschreibung

Die Erfindung betrifft ein Mittel und ein Verfahren zur Herstellung von wasserabweisenden Beschichtungen auf optischen Substraten.

Es ist verbreiteter Stand der Technik, die Oberflächen von optischen Bauteilen mit dünnen Beschichtungen zu deren Schutz oder zur Erzielung bestimmter Funktionseigenschaften zu versehen. Als derartige optische Bauteile sind im wesentlichen optische Linsen, Brillengläser, Objektive für Kameras, Ferngläser oder für andere optische Geräte, Strahlenteiler, Prismen, Spiegel, Fensterscheiben usw. zu verstehen. Zum einen ist Ziel derartiger Beschichtungen, die Oberflächen von optischen Substraten dahingehend zu vergüten, daß durch Härtung und/oder Erhöhung der chemischen Resistenz Schädigungen durch mechanische, chemische oder Umwelteinflüsse vermieden werden. Dies steht im besonderem Maße bei Substraten aus Kunststoffmaterialien im Vordergrund. Zum anderen werden Oberflächenbeschichtungen zur Verminderung der Reflexion eingesetzt, insbesondere bei Brillengläsern und Objektiven. Hierbei kann bei geeigneter Wahl der Beschichtungsmaterialien, Schichtdicke, ein- oder mehrschichtigem Aufbau aus gegebenenfalls unterschiedlichen Materialien mit differierenden Brechungsindizes eine Reduktion der Reflexion auf unter 1 % über das gesamte sichtbare Strahlungsspektrum erreicht werden.

Zur Erzeugung derartiger Vergütungs- bzw. Antireflexschichten dienen zahlreiche oxidische Materialien, wie etwa SiO₂, TiO₂, ZrO₂, MgO, Al₂O₃, auch Fluoride wie MgF₂ sowie Gemische dieser Stoffe. Die Beschichtung von optischen Substraten erfolgt üblicherweise in der Hochvakuumaufdampftechnik. Hierbei wird das Substrat und eine die Aufdampfsubstanz enthaltende Vorlage in eine entsprechende Hochvakuumaufdampfapparatur plaziert, anschließend wird die Apparatur evakuiert und dann die Substanz durch Erhitzen und/oder Elektronenstrahlverdampfung zur Verdampfung gebracht, wobei sich das Aufdampfmaterial auf der Substratoberfläche als dünne Schicht niederschlägt. Entsprechende Apparaturen und Verfahren sind gängiger Stand der Technik.

Vergütungsschichten dieser Art, insbesondere Antireflexschichten sind jedoch äußerst empfindlich gegenüber Verschmutzungen, beispielsweise durch feuchte bzw. fettige Fingerabdrücke. Durch Verunreinigungen wird die Reflexion stark erhöht; Fingerabdrücke werden deshalb deutlich sichtbar. Eine effektive, den ursprünglichen Reflexionswert wiederherstellende Reinigung gestaltet sich als schwierig. Aus diesem Grund hat es sich durchgesetzt, optische Bauteile zusätzlich mit einer hydrophobisierenden, also wasserabweisenden Beschichtung, zu versehen.

Zur Hydrophobisierung der Oberflächen von optischen Substraten stehen eine Reihe von Stoffen, insbesondere aus der Klasse der Organosiliciumverbindungen zur Verfügung. Es sind dies beispielsweise Silane, Siloxane, Silikone und Silikonöle. Diese Substanzen werden in aller Regel im Tauchverfahren oder im Aufschleuderverfahren auf die zu behandelnden Substratoberflächen aufgebracht, wobei diese Substanzen entweder in reiner Form oder als Lösungen eingesetzt werden. Nach Oberflächenbehandlung und gegebenenfalls Abdunsten von Lösungsmittel erfolgt meist eine thermische Nachbehandlung, wodurch die wasserabweisende Beschichtung verfestigt und die Haftung mit dem Substratmaterial bewirkt wird. Man erhält hierdurch in der Regel Beschichtungen mit zufriedenstellenden Eigenschaften bezüglich Hydrophobisierung, Haltbarkeit und Dauerhaftigkeit.

Die durch die Natur der üblichen Hydrophobisierungsmittel bedingte Beschichtungstechnik ist jedoch nachteilig.

So ist es bei der Tauchbeschichtung und der Aufschleudertechnik erforderlich, unter strikten Reinraumbedingungen zu arbeiten um Qualitätsbeeinträchtigungen, etwa durch Staubpartikel, auszuschließen. Weiterhin erfordern diese Techniken zusätzliche Arbeitsgänge mit entsprechenden Apparaturen und Anlagen.

In JP 05-170 487 wird ein Verfahren zur Herstellung von monomolekularen wasserabweisenden Schichten mittels Fluorsilanen beschrieben, in welchem die Fluorsilane enthaltenden Lösungen bei 100 bis 400 °C pyrolysiert werden.

Aus der US 4 944 962 ist eine Tauchbeschichtung von Kunststofflinsen mit Fluoralkylsilanen bekannt, die nach einer vorherigen Beschichtung mit einer Antireflexschicht ausgeführt wird. Dazu müssen die zu beschichtenden Substrate aus der Bedampfungsanlage entnommen und in eine zweite Apparatur überführt werden.

JP 05-239 423 offenbart die Herstellung wasserabweisender Schichten in einer Vakuumapparatur mit Hilfe von Fluoralkylsilanen. Dabei wird eine wasser- und ölabweisende Schicht auf dem zu beschichtenden Objekt durch gleichzeitige Zuführung von Fluoralkylsilan und Wasser in die Verdampfungsanlage erzeugt, wobei das Silan hydrolysiert wird.

JP 06-122 962 beschreibt ein Verfahren zur Beschichtung von Glas, Keramik, Metallen, Kunststoffen und Fasern mit Fluoralkylsilanen. Dabei wird das Silan nach dem Evakuieren der Beschichtungsanlage in diese eingespeist. Es werden Schichtdicken im Angströmbereich aufgetragen.

In der EP 0 561 016 wird das Aufbringen von Schutzschichten auf optische Teile durch Verdampfen von Polyethylenwachs, Siliconharz und Urethanmonomeren aus einem porösen Keramikmaterial durch Erhitzen im Vakuum beschrieben. Das Verdampfen von Silanen wird nicht offenbart.

Aus JP 05-215 905 ist ein Verfahren zur Erzeugung von wasserabweisenden Beschichtungen auf optischen Substraten bekannt, bei dem Fluoralkylsilazanverbindungen mittels der Hochvakuumaufdampftechnik auf die Substratoberfläche aufgebracht werden. Dieses Verfahren ist gegenüber den üblichen Tauch- und Aufschleudertechniken dahingehend vorteilhaft, weil es ohne weiteres in bestehenden Hochvakuumaufdampfapparaturen durchgeführt werden kann, etwa gleich im Anschluß an die Bedampfung des Substrates mit Antireflex- oder anderen Vergütungsschichten. Die Perfluoralkylsilazanverbindungen werden bevorzugt in einer Form vorgelegt bei der ein poröser metallischer Sinterkörper mit der Substanz getränkt ist.

Es hat sich jedoch herausgestellt, daß der Einsatz von Polyfluoralkylsilazanverbindungen in einem derartigen Hochvakuumaufdampfverfahren nachteilig ist. Die Substanzen an sich sind bereits instabil, was sich durch ihren deutlichen Ammoniakgeruch zu erkennen gibt. Sie zersetzen sich und sind nicht lagerstabil. Bei der Bedampfung erleiden die Verbindungen eine zumindest teilweise Zersetzung, bei der Ammoniakgas freigesetzt wird. Dieses verursacht Korrosion in der Apparatur und den zugehörigen Hochvakuumpumpen sowie gegebenenfalls an den optischen Substraten; weiterhin besteht die Gefahr der Reaktion des Ammoniak mit den Pumpenölen in den Hochvakuumpumpen.

Der Erfindung lag daher die Aufgabe zugrunde, ein einfaches Verfahren für die Erzeugung von haltbaren und widerstandsfähigen wasserabweisenden Schichten in üblichen Hochvakuumbedampfungsanlagen bereitzustellen. Eine weitere Aufgabe bestand darin, ein geeignetes Mittel für die Hochvakuumbedampfung von wasserabweisenden Schichten zur Verfügung zu stellen.

Gegenstand der Erfindung ist ein Verfahren zur Herstellung von wasserabweisenden Beschichtungen auf optischen Substraten durch thermisches Bedampfen mit Organosilanverbindungen im Hochvakuum bei einem Druck von 0,1 bis 0,001 Pa (10⁻³ bis 10⁻⁵ mbar), wobei
- eine poröse, anorganisch-oxidische Matrix aus SiO₂, TiO₂, ZrO₂, MgO, Al₂O₃ oder Mischungen hiervon mit mindestens einer Verbindung der Formel

   CₙF₂ₙ₊₁-(CH₂)ₘ-Si(R¹R²R³) (I)

   worin
   - R¹: Alkoxy mit 1 bis 3 C-Atomen oder CₙF₂ₙ₊₁-(CH₂)ₘ-Si(R²R³)-O-
   - R², R³: Alkyl oder Alkoxy mit 1 bis 3 C-Atomen
   - n: 1 bis 12
   - m: 1 bis 6
   bedeuten, imprägniert wird,
- die Verbindungen der Formel I aus der porösen, anorganisch-oxidischen Matrix im Hochvakuum bei 300-500 °C verdampft werden und
- die verdampften Verbindungen auf der Oberfläche eines auf 50-300 °C vorgeheizten optischen Substrates niedergeschlagen werden.

Gegenstand der Erfindung ist weiterhin ein Mittel zur Herstellung von wasserabweisenden Beschichtungen auf optischen Substraten, bestehend aus einer porösen anorganisch-oxidischen Matrix aus SiO₂, TiO₂, ZrO₂, MgO, Al₂O₃ oder Mischungen hiervon die eine Verbindung der Formel I enthält, hergestellt durch
a) Verpressen und Sintern eines pulvrigen anorganischen Oxidmaterials zu einem porösen Formkörper, und
b) Imprägnieren des Formkörper mit einer Verbindung der Formel I.

In den Organosiliciumverbindungen der Formel I ist ein Rest eine Polyfluoralkylgruppe, zusammengesetzt aus einer terminalen Perfluoralkylgruppe mit 1 bis 12 C-Atomen, die über eine Alkylengruppe mit 1 bis 6 C-Atomen mit dem Siliciumatom verbunden ist. Von den weiteren mit dem Siliciumatom verbundenen Resten R¹, R² und R³ ist mindestens ein Rest (R¹) eine Alkoxygruppe mit 1 bis 3 C-Atomen. Die weiteren Reste (R², R³) können Alkyl- oder Alkoxygruppen mit jeweils 1 bis 3 C-Atomen sein. Der Rest R¹ kann auch eine Siloxylgruppe sein, in der ein Rest eine wie vorstehend beschriebene Polyfluoralkylgruppe ist. Die beiden anderen mit dem Siliciumatom verbundenen Reste (R², R³) können wiederum die bereits definierten Alkyl- oder Alkoxygruppen sein. Typische Verbindungen der Formel I sind beispielsweise
Triethoxy(3,3,4,4,5,5,6,6,7,7,7-undecafluoroheptyl)silan
Triethoxy(3,3,4,4,5,5,6,6,7,7,8,8,8-tridecafluorooctyl)silan
Triethoxy(3,3,4,4,5,5,6,6,7,7,8,8,9,9,10,10,10-heptadecafluoro-decyl)silan
Diethoxymethyl(3,3,4,4,5,5,6,6,7,7,8,8,9,9,10,10,10-heptadecafluorodecyl)silan
Bis[ethoxymethyl(3,3,4,4,5,5,6,6,7,7,8,8,8-tridecafluorooctyl)]silylether.

Die Verbindungen der Formel I sind an sich bekannt und überwiegend im Handel erhältlich. Im übrigen sind sie ohne weiteres nach bekannten Herstellverfahren zugänglich.

Die Verbindungen der Formel I sind ausnehmend stabil und insbesondere lagerstabil.

Es hat sich gezeigt, daß sie im Hochvakuum bei Temperaturen zwischen 300 und 500 °C ohne weiteres verdampft werden können, wobei sie sich auf Substratoberflächen unter Bildung dünner Schichten niederschlagen. In diesem Prozeß sind die Verbindungen der Formel I entweder unzersetzlich oder entsprechende Spaltprodukte sind in keinster Weise aggressiv oder korrosiv gegenüber optischen Substraten oder den Bestandteilen von Hochvakuumbedampfungsanlagen, Vakuumpumpen und Pumpenölen.

Für das erfindungsgemäße Verfahren zur Erzeugung von wasserabweisenden Schichten auf optischen Substraten können Hochvakuumbedampfungsanlagen eingesetzt werden, wie sie zur Erzeugung optischer Schichten wie insbesondere Antireflexschichten oder Vergütungsschichten zur Oberflächenhärtung üblich sind. Hierbei werden die Verbindungen der Formel I in geeigneter Form und Weise anstatt der sonstigen Bedampfungsmaterialien in der Apparatur vorgelegt. Zweckmäßig ist der direkte Anschluß des Bedampfungsschrittes mit Verbindungen der Formel I an vorangehende Bedampfungsprozesse, etwa zur Aufbringung von Antireflexschichten, wobei das Substrat sich bereits in der Anlage befindet.

Nach Aufbringen der Vergütungsschichten ist keine weitere Vorbehandlung der Substrate vor dem Bedampfen im Vakuum notwendig.

Die Verbindungen der Formel I werden in der Bedampfungsapparatur in einer porösen anorganisch-oxidischen Matrix vorgelegt. Ein Mittel zur Herstellung von wasserabweisenden Beschichtungen auf optischen Substraten durch Bedampfung im Hochvakuum besteht demnach aus einer porösen anorganisch-oxidischen Matrix, die eine Verbindung der Formel I enthält. Die poröse anorganisch-oxidische Matrix besteht aus SiO₂, TiO₂, ZrO₂, MgO, Al₂O₃ oder Mischungen hiervon. Derartige Mittel sind ebenfalls Gegenstand der Erfindung. Die Herstellung dieser Mittel erfolgt in der Weise, daß man das Matrixmaterial, das üblicherweise in feinteiliger Form mit Partikelgrößen zwischen 5 µm und 20µm vorliegt, zu Tabletten verpresst und diese dann in der für das jeweilige Material üblichen Weise einer Sinterung unterzieht.

Für diesen Sinterschritt sind für die genannten Materialien Temperaturen zwischen 900 und 1400 °C über einen Zeitraum von 1 bis 10 Stunden typisch. Die erhaltenen porösen Sinterkörper weisen je nach Korngröße der Primärpartikel, Verdichtung und Sinterbedingungen eine Porosität von 40 bis 60 % auf. Die von der porösen anorganisch-oxidischen Matrix gebildeten Sinterkörper können dann mit den Verbindungen der Formel I beladen werden. Dies geschieht durch Tränken oder Betropfen der Sinterkörper mit Verbindungen der Formel I, sofern diese flüssig sind, oder mit Lösungen von Verbindungen der Formel I. Es ist zweckmäßig die Sinterkörper mit vorherbestimmten Mengen an Verbindung der Formel I zu beladen, da sich durch die quantitative Determinierung des Gehaltes eines jeden solchen beladenen Körpers die Schichtdicke auf dem zu beschichtenden optischen Substrat einfach vorbestimmen läßt.

Zur Herstellung von wasserabweisenden Beschichtungen auf optischen Substraten genügt es eine Hochvakuumbedampfungsanlage konventioneller Art, in die das zu beschichtende Substrat eingesetzt worden ist, mit einer Verbindung der Formel I in Form eines mit der Verbindung beladenen anorganisch-oxidischen Formkörpers zu beschicken. Bei Erreichen eines stabilen Endvakuums im Bereich zwischen 0,1 und 0,001 Pa (10⁻³ und 10⁻⁵ mbar) wird durch Erhitzen auf Temperaturen von 300 bis 500 °C die Verdampfung der Verbindung der Formel I bewirkt. Diese schlägt sich im Verlaufe des Prozesses auf der Oberfläche des optischen Substrates unter Bildung einer dünnen Schicht nieder. Zur Verbesserung der Schichthaftung wird das Substrat auf eine Temperatur zwischen 50 und 300 °C beheizt. Die zu erzielende Schichtdicke ist abhängig von der Prozeßdauer oder bei quantitativer Verdampfung von der Menge an vorgelegter Verbindung der Formel I. Üblicherweise werden für derartige wasserabweisende Beschichtungen Schichtdicken zwischen 2 und 200 nm eingestellt.

Die nach dem erfindungsgemäßen Verfahren erzeugten wasserabweisenden Beschichtungen zeigen gegenüber mit bisher hierfür eingesetzten Materialien hergestellten Schichten einige unvorhersehbare Vorteile. Neben der Tatsache, daß die Beschichtungen ein vorzügliches wasserabweisenden Verhalten zeigen, sind sie gegenüber mechanischen und chemischen Einflüssen erheblich resistenter. Sie sind wesentlich haftfester und haltbarer; ihre Widerstandsfähigkeit gegenüber Wischen und Kratzen sowie ihre Stabilität gegenüber feuchtwarmer Luft, physiologischer Kochsalzlösung, erhöhter Temperatur oder Einwirkung von UV-Strahlung ist wesentlich höher als bei Beschichtungen mit Materialien und Verfahren nach dem Stand der Technik.

Wasserabweisende Schichten mit Verbindungen der Formel I nach dem erfindungsgemäßen Verfahren können auf allen beliebigen optischen Substraten aufgebracht werden. Ihr Einsatz ist insbesondere vorteilhaft auf optischen Substraten, die vorher mit dünnen Schichten zur Oberflächenvergütung und/oder Reflexionsverminderung versehen worden sind.

### Beispiel 1

Aus einem Gemisch bestehend aus 20 Gew.-% SiO₂ und 80 Gew.-% Al₂O₃ mit Partikelgröße 1 bis 10µm werden mit einer hydraulischen Presse Tabletten mit Durchmesser 10 mm und Höhe 8 mm gepreßt. Diese Tabletten werden dann bei 1200 °C über 14 Stunden gesintert. Die gesinterten Formkörper besitzen eine Porosität von ca. 40 %.

### Beispiel 2

Die Formkörper nach Beispiel 1 werden solange in eine Lösung aus 1 ml Triethoxy(3,3,4,4,5,5,6,6,7,7,7-undecafluoroheptyl)silan in 10 ml Isopropanol getaucht bis sie vollständig vollgesogen sind. Nach Entnahme aus der Lösung und Abdunsten des Lösungsmittels enthält jede Tablette ca. 2 Gew.-% an Silanverbindungen.

### Beispiel 3

Eine Tablette gemäß Beispiel 2 wird in ein Schiffchen aus Molybdänblech gelegt und dieses in die Verdampfereinrichtung einer handelsüblichen Hochvakuumverdampfungsanlage (A 700 Q, Firma Leybold) gesetzt. Die zu beschichtenden Glasscheiben der Abmessung 5 x 5 cm werden auf dem Substratträger der Anlage befestigt. Die Anlage wird dann bis zu einem Restdruck von 0,002 Pa (2 x 10⁻⁵ mbar) evakuiert. Die Substrate werden auf ca. 80 °C aufgeheizt. Die Verdampfereinrichtung wird auf ca. 350 °C erhitzt. Hierbei verdampft die in der Tablette enthaltene Substanz und schlägt sich auf den Glasscheiben unter Schichtbildung nieder. Nach einer Dauer von 30 Sek. wird abgekühlt und die Anlage belüftet. Die Schichtdicke auf den Substraten wird zu 5 nm bestimmt. Die Schichten sind wasserabstoßend; aufgebrachte Wassertropfen benetzen sie nicht, sondern perlen ab.

## Patentansprüche

1. Verfahren zur Herstellung von wasserabweisenden Beschichtungen auf optischen Substraten durch thermisches Bedampfen mit OrganosilanVerbindungen im Hochvakuum bei einem Druck von 0,1 bis 0,001 Pa (10⁻³ bis 10⁻⁵ mbar), indem
- eine poröse, anorganisch-oxidische Matrix aus SiO₂, TiO₂, ZrO₂,MgO, Al₂O₃ oder Mischungen hiervon mit mindestens einer Verbindung der Formel
CₙF₂ₙ₊₁-(CH₂)ₘ-Si(R¹R²R³) (I)
worin
R¹ Alkoxy mit 1 bis 3 C-Atomen oder CₙF₂ₙ₊₁-(CH₂)ₘ-Si(R¹R²R³)-O-
R², R³ Alkyl oder Alkoxy mit 1 bis 3 C-Atomen
n 1 bis 12
m 1 bis 6
bedeuten, imprägniert wird,
- die Verbindung der Formel I aus der porösen, anorganisch-oxidischen Matrix im Hochvakuum bei 300-500 °C verdampft werden und
- die verdampften Verbindungen auf der Oberfläche eines auf 50-300 °C vorgeheizten optischen Substrates niedergeschlagen werden.

2. Verfahren nach Anspruch 1, bei dem das optische Substrat mindestens eine Schicht zur Oberflächenvergütung und/oder Reflexionsverminderung besitzt.

3. Mittel zur Herstellung von wasserabweisenden Beschichtungen auf optischen Substraten nach einem Verfahren gemäß den Ansprüchen 1 und 2, bestehend aus einer porösen anorganisch-oxidischen Matrix aus SiO₂, TiO₂, ZrO₂, MgO, Al₂O₃ oder Mischungen hiervon die eine Verbindung der Formel I enthält, hergestellt durch
a) Verpressen und Sintern eines pulverigen anorganischen Oxidmaterials zu einem porösen Formkörper, und
b) Imprägnieren des Formkörper mit einer Verbindung der Formel I.

## Claims

1. Method of preparing water-repellent coatings on optical substrates by thermal vapour coating with organosilane compounds in a high vacuum at a pressure of from 0.1 to 0.001 Pa (from 10⁻³ to 10⁻⁵ mbar), **characterized in that**
- a porous, inorganic oxide matrix comprising SiO₂, TiO₂, ZrO₂, MgO, Al₂O₃ or mixtures thereof is impregnated with at least one compound of the formula
CₙF₂ₙ₊₁-(CH₂)ₘ-Si(R¹R²R³) (I)
in which
R¹ is alkoxy having 1 to 3 carbon atoms or CₙF₂ₙ₊₁-(CH₂)ₘ-Si(R¹R²R³)-O-
R² and R³ are alkyl or alkoxy having 1 to 3 carbon atoms
n is 1 to 12
m is 1 to 6,
- the compound of the formula I is evaporated from the porous, inorganic oxide matrix in a high vacuum at 300-500°C and
- the evaporated compounds are deposited on the surface of an optical substrate preheated to 50-300°C.

2. Method according to Claim 1, **characterized in that** the optical substrate possesses at least one coat for surface upgrading and/or reflection reduction.

3. Material for preparing water-repellent coatings on optical substrates by a method according to Claims 1 and 2, consisting of a porous inorganic oxide matrix comprising SiO₂, TiO₂, ZrO₂, MgO, Al₂O₃ or mixtures thereof and containing a compound of the formula I, prepared by
a) pressing and sintering a pulverulent inorganic oxide material to form a porous shaped article, and
b) impregnating the shaped article with a compound of the formula I.

## Revendications

1. Procédé de fabrication de revêtements imperméables à l'eau sur des substrats optiques par évaporation thermique de composés organosilanes sous vide élevé à une pression de 0,1 à 0,001 Pa (10⁻³ à 10⁻⁵ mbar) dans lequel :
◆ une matrice poreuse d'oxydes inorganiques constituée de SiO₂, TiO₂, ZrO₂, MgO, Al₂O₃ ou des mélanges de ceux-ci est imprégnée d'au moins un composé de la formule :
CₙF₂ₙ₊₁-(CH₂)ₘ-Si(R¹R²R³) (I)
où
R¹ est un alcoxy à 1 à 3 atomes de carbone ou CₙF₂ₙ₊₁-(CH₂)ₘ-Si(R¹R²R³)-O-
R², R³ sont des alkyles ou des alcoxy à 1 à 3 atomes de carbone,
n = 1 à 12
m = 1 à 6
◆ le composé de formule (I) est évaporé hors de la matrice poreuse en oxyde inorganique à 300 à 500°C sous un vide élevé et
◆ les composés évaporés sont déposés sur la surface d'un substrat optique préchauffé à 50 à 300°C.

2. Procédé selon la revendication 1, dans lequel le substrat optique possède au moins une couche de traitement superficiel anti-reflet et/ou de réduction de réflexion.

3. Moyen de fabrication de couches imperméables à l'eau sur des substrats optiques selon un procédé conforme aux revendications 1 ou 2, qui se compose d'une matrice poreuse d'oxydes inorganiques, constituée de SiO₂, TiO₂, ZrO₂, MgO, Al₂O₃ ou des mélanges de ceux-ci, qui contient un composé de la formule (I), fabriqué par les étapes consistant à :
a) comprimer et fritter une matière pulvérulente d'oxydes inorganiques pour constituer un corps de forme poreux ; et
b) imprégner le corps de forme à l'aide d'un composé de la formule (I).
